# FASCICULE DE BREVET EUROPEEN

(11) **EP 4 028 576 B1**
(45) Date de publication et mention de la délivrance du brevet: **01.11.2023**
(21) Numéro de dépôt: 20767856.6
(22) Date de dépôt: 11.09.2020
(51) Int. Cl.: C23C 18/16, C23C 18/54, C23C 18/38, C23C 18/32, C23C 18/20, B23K 35/02

(54) **BILLES DE SOUDURE COMPOSITES METALLISEES EN SURFACE ET CALIBREES POUR L'ASSEMBLAGE DE CARTES ELECTRONIQUES**
AUF DER OBERFLÄCHE METALLISIERTE UND KALIBRIERTE VERBUNDLÖTKUGELN ZUR MONTAGE VON ELEKTRONISCHEN PLATTEN
COMPOSITE SOLDER BALLS METALLISED ON THE SURFACE AND CALIBRATED FOR THE ASSEMBLY OF ELECTRONIC BOARDS

(30) Priorité: 12.09.2019 FR 1910055
(43) Date de publication de la demande: 20.07.2022
(73) Titulaire: "Institut de Recherches en Ingéniérie des Surfaces", 42160 Andrézieux-Bouthéon (FR)
(72) Inventeur: IACOB, Constantin, 76690 SAINT GEORGES SUR FONTAINE (FR); BUCHER, Sébastien, 42000 SAINT ETIENNE (FR)
(74) Mandataire: Novagraaf Technologies
(86) Numéro de dépôt international: PCT/EP2020/075498
(87) Numéro de publication internationale: WO 2021/048374

(56) Documents cités:
- JP-A- 2007 044 718
- JP-B2- 6 500 583
- US-A1- 2016 244 891

## Description

La présente invention concerne de manière générale la fabrication de billes de soudure composites et l'utilisation de ces billes comme solution d'interconnexion pour l'assemblage de cartes électroniques.

La recherche de technologies pour l'assemblage de cartes électroniques de plus en plus miniaturisées et n'utilisant pas de plomb incitent de plus en plus les acteurs industriels dans ce domaine technologique à chercher des solutions innovantes pour réaliser des interconnexions entre des composants sensibles aux contraintes mécaniques, par exemple des matrices de billes de type CBGA (acronyme anglais pour « *Ceramic Ball Grid Array* »)*,* ou des microsystèmes électromécaniques (couramment désignés par l'acronyme anglais MEMS pour « Micro *Electro Mechanical System* »). Le document JP6500583 divulgue un procédé de fabrication de billes de soudure composites métallisées en surface.

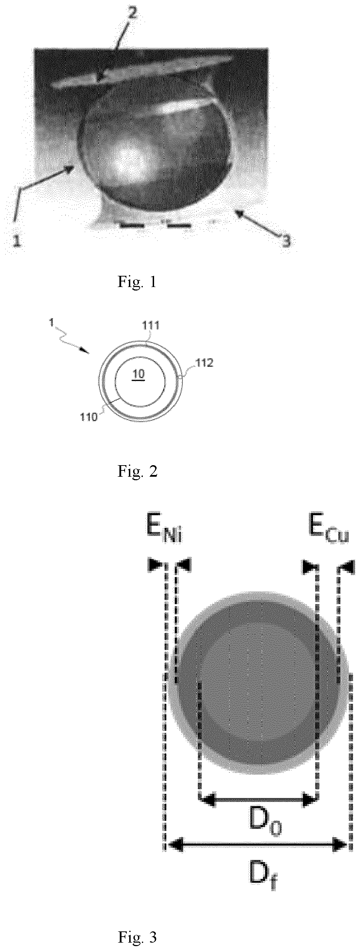

Les billes souples (telles qu'illustrées sur [Fig. 1]) sont une des technologies utilisées pour réaliser des systèmes dans un boitier, généralement désignés par l'acronyme anglais SiP (pour « *System In Package* »). Elles présentent des contacts à souder permettant facilement leur assemblage dans le boitier.

Toutefois, à l'heure actuelle, les billes souples actuellement utilisées dans ce domaine présentent l'inconvénient d'être constituées d'un coeur dense en matériau polymère impactant négativement les coûts de fabrications liés aux rendements des processus de fabrication et de calibration des billes initiales, ainsi qu'à la densité finale de la bille. D'autre part, des problèmes de dilatations thermiques différentielles peuvent être rencontrés entre le coeur et l'enveloppe métallique des particules lors des opérations de brasages ultérieures.

Afin de remédier à cet inconvénient, le Demandeur a mis au point un procédé de fabrication de billes de soudure composites métallisées en surface et calibrées, lesdites billes comprenant un coeur constitué par une particule support de forme sphérique de diamètre D₀, en polystyrène expansé (PSE) et présentant une porosité intragranulaire d'au moins 50%, et une enveloppe recouvrant ladite particule support et formée par une pluralité de couches superficielles métalliques, comprenant notamment un revêtement de cuivre d'épaisseur E_{cu}, au moins une couche de nickel d'épaisseur E_{Ni}, et une couche de finition d'or d'une épaisseur E_{Au} de telle sorte que la particule finale possède un diamètre D_{f}.

Selon l'invention, le procédé est caractérisé en ce qu'il comprend les étapes suivantes:
A) une première étape de fourniture de particules support, suivie par
B) une première étape de tri granulométrique desdites particules support, consistant en une étape de séparation physique et/ou mécanique des particules support présentant un diamètre D₀ avec une tolérance +/-5% tel que D₀ = D_{f}-2^{∗}(E_{Ni}+E_{Cu}+E_{Au}), Do pouvant être choisi entre 200 µm et 1000 µm ;
C) une étape de traitement d'activation des particules support ainsi sélectionnées, pour obtenir des particules support activées ;
D) une première étape de métallisation desdites particules support activées par dépôt chimique auto-catalytique d'une ou plusieurs couches de cuivre, cette étape étant répétée jusqu'à obtention d'une épaisseur Ecu de couche de cuivre comprise entre 15 µm et 35 µm, pour obtenir des particules support revêtues de cuivre ;
E) une deuxième étape de métallisation des particules support revêtues de cuivre par dépôt chimique auto-catalytique d'au moins une couche de nickel allié à du phosphore NiP avec un pourcentage massique de 7 à 10% de phosphore par rapport au poids total de ladite couche de NiP, cette étape étant conduite jusqu'à obtention d'une épaisseur E_{Ni} de couche de nickel chimique comprise entre 4 µm et 7 µm, pour obtenir des particules support revêtues de nickel chimique ;
F) une troisième étape de métallisation des particules support revêtues de nickel chimique (consistant en une étape de dépôt d'or par un procédé de déplacement galvanique réalisé par immersion dans une solution aqueuse contenant des ions d'or (réalisée classiquement conformément à l'état de l'art), de manière à obtenir des billes de soudure composites métallisées et revêtues en surface d'une couche de finition d'or d'une épaisseur E_{Au} comprise entre 0,05 µm et 0,12 µm ;
G) une deuxième étape de tri granulométrique des particules ainsi métallisées pour trier et sélectionner des billes (1) de soudure composites métallisées en surface présentant un diamètre D_{f} avec une tolérance de +/-5%.

Les billes de polystyrène expansé (PSE) présentent l'avantage de pouvoir diminuer en taille lorsqu'on les chauffe et offre ainsi la possibilité d'être calibrées par traitement thermique.

Par porosité intragranulaire, on entend, au sens de la présente invention la porosité interne d'une particule support, à la surface et/ou à l'intérieur de laquelle on peut observer différents types de pores : canaux, réseaux, "poches", pores non débouchant et rugosité de surface. Elle peut se mesurer par exemple par pycnométrie Hélium.

La première étape du procédé selon l'invention est l'étape de fourniture de particules support (étape A).

De manière avantageuse, on pourra utiliser des billes de polystyrène expansé (PSE) présentant un taux de porosité intragranulaire supérieur à 90%.

Dans le procédé selon l'invention, on commence par procéder à un premier tri granulométrique de ces particules support (étape B), consistant en une étape de séparation physique et/ou mécanique des particules support (10) présentant un diamètre D₀ choisi entre 200 µm et 1000 µm. Selon un mode de réalisation avantageux du procédé selon l'invention, l'étape de tri granulométrique B) des particules support pourra consister en un tamisage mécanique pour trier et sélectionner les particules support présentant un diamètre _{D0} choisi entre 200 µm et 1000 µm. En pratique, on choisira des particules support dont la taille correspond à la valeur cible D₀ +/- 5%.

Si l'on utilise comme particules support des billes de polystyrène expansé (PSE), l'étape de tri granulométrique B) des particules support pourra consister en un tamisage mécanique des particules support. Il peut ensuite être avantageusement complété par un traitement thermique à une température comprise entre 100°C et 120°C, et de préférence entre 110 °C et 120°C, de la tranche supérieure des particules ainsi triées (c'est-à-dire les particules dont la taille est supérieure à D₀ +5%, afin d'augmenter le rendement de calibration de la population de billes initiale. En effet, étant donné que le diamètre des billes de polystyrène expansé (PSE) diminue lorsqu'elles sont chauffées, si l'on couple le tamisage mécanique à un chauffage, le refus au tamis de la tranche supérieure des billes précédemment triées peut alors être réduit en diamètre, de sorte que ces billes initialement rebutées atteignent le diamètre D₀+/-5% visé. Ceci permet notamment de diminuer significativement le coût de production en augmentant le rendement du nombre de billes présentant un diamètre D₀. Cette étape de traitement thermique peut avantageusement être menée en lit fluidisé par voie gazeuse ou par voie liquide afin de conserver la sphéricité initiale des billes.

A l'issue de l'étape de tri granulométrique B), on procède à un traitement d'activation (étape C) des particules support précédemment sélectionnées, pour obtenir des particules support activées.

Par traitement d'activation, on entend, au sens de la présente invention, un traitement consistant à activer la surface des particules support afin de permettre une bonne accroche du traitement de métallisation ultérieur.

Un premier mode de réalisation avantageux de ce traitement d'activation pourra par exemple consister à déposer, à la surface des particules support précédemment sélectionnées, des germes d'argent par réduction d'ions argent en solution, le dépôt d'argent se faisant par germination-croissance. L'opération peut par exemple être conduite par réduction d'un nitrate d'argent ammoniacal dans une solution à base de glycol.

Un autre mode de réalisation avantageux de ce traitement d'activation pourra aussi consister à déposer, à la surface des particules support précédemment sélectionnées, du cuivre en couche mince inférieure ou égale à 1 µm, par dépôt physique en phase vapeur (PVD).

Une fois les particules support activées, on procède alors à la métallisation proprement dite des particules (étapes D à F).

La première étape de métallisation (étape D) des particules support activées est une étape de dépôt chimique auto-catalytique d'une ou plusieurs couches de cuivre, cette étape étant répétée jusqu'à obtention d'une épaisseur Ecu de couche de cuivre comprise entre 15 µm et 35 µm, pour obtenir des particules support revêtues de cuivre. Plusieurs métallisations successives peuvent être nécessaires pour obtenir l'épaisseur de cuivre souhaitée.

Si l'on souhaite que les billes de soudure soient des billes creuses ou quasi-creuses, on pourra réaliser entre les étapes D et E de métallisation, soit une dissolution partielle ou totale, soit une décomposition par voie thermique partielle ou totale du polystyrène expansé (PSE) constitutif des particules support. Pour cela, la couche de cuivre formée à l'étape E devra alors être soit suffisamment fine, soit suffisamment poreuse pour permettre la disparition du PSE.

La deuxième étape de métallisation (étape E) consiste à métalliser les particules support revêtues de cuivre obtenues à l'issue de l'étape D) (éventuellement transformées en billes creuses ou quasi creuses) par dépôt chimique auto-catalytique d'au moins une couche de nickel allié à du phosphore NiP avec un pourcentage massique de 7 à 10% de phosphore par rapport au poids total de la couche de NiP (ou nickel chimique). Cette étape E) est conduite jusqu'à obtention d'une épaisseur ENi de couche de nickel chimique (111) comprise entre 4 µm et 7 µm, pour obtenir des particules support revêtues de nickel chimique.

La troisième étape de métallisation (étape F) consiste à métalliser les particules support revêtues de nickel chimique par immersion dans une solution contenant des ions d'or, de manière à obtenir des billes de soudure composites métallisées et revêtues en surface d'une couche de finition d'or d'une épaisseur E_{Au} comprise entre 0,05 µm et 0,12 µm.

Enfin, la dernière étape du procédé selon l'invention (étape G) est une deuxième étape de tri granulométrique des particules ainsi métallisées pour trier et sélectionner des billes de soudure composites métallisées en surface présentant un diamètre D_{f} avec une tolérance de +/-5%.

La présente invention a également pour objet des billes de soudure susceptibles d'être obtenues par le procédé de fabrication selon l'invention.

Selon un premier mode de réalisation particulièrement avantageux de l'invention, les billes de soudure peuvent présenter les caractéristiques suivantes :
- diamètre D₀ de l'ordre de 630 µm +/-5%,
- épaisseur de la couche de cuivre Ecu de l'ordre de 30 µm,
- épaisseur de la couche de NiP E_{Ni} de l'ordre de 5 µm,
- épaisseur de la couche d'or EAu comprise entre 0.05 µm et 0,12 µm,
- diamètre Df de l'ordre de 700µm +/-5%.

Selon un deuxième mode de réalisation particulièrement avantageux de l'invention, les billes de soudure peuvent présenter les caractéristiques suivantes :
- diamètre D₀ de l'ordre de 350 µm +/-5% µm,
- épaisseur de la couche de cuivre Ecu de l'ordre de 20 µm,
- épaisseur de la couche de NiP E_{Ni} de l'ordre de 5 µm,
- épaisseur de la couche d'or E_{Au} de l'ordre de 0.1 µm,
- diamètre Df de l'ordre de 400µm +/-5%.

De manière avantageuse, les billes de soudure selon l'invention peuvent être des billes creuses (ou quasi creuses) comprenant un coeur constitué d'au plus 50% en volume de matériau polymère lorsqu'il s'agit de polystyrène expansé (PSE). De telles billes de soudure sont obtenues avec le procédé selon l'invention lorsque ce dernier comporte, entre les étapes D) et E), une étape de dissolution partielle ou totale une étape de décomposition par voie thermique partielle ou totale du polystyrène expansé (PSE) constitutif des particules support de départ.

La présente invention a encore pour objet l'utilisation des billes selon l'invention, pour l'assemblage de cartes électroniques. En effet, la structure des billes selon l'invention permet de réaliser des interconnexions entre des composants sensibles aux contraintes mécaniques (CBGA, MEMS ...). Elles présentent en outre l'avantage, d'une part de maintenir un positionnement maitrisé, et d'autre part de limiter les contraintes mécaniques dans les interconnections entre substrat et composants.

D'autres avantages et particularités de la présente invention résulteront de la description qui va suivre, donnée à titre d'exemple non limitatif et faite en référence aux dessins annexes dans lesquelles :
[Fig. 1] est une représentation schématique d'un exemple de bille souple connue de l'art antérieur avec des contacts à souder pour leur assemblage dans des boitiers de circuits intégrés,
[Fig. 2] est une représentation schématique d'un exemple de bille souple selon l'invention,
[Fig. 3] est également une représentation schématique d'un exemple de bille souple selon l'invention, mais dans laquelle pour raisons de clarté la couche d'or superficielle n'a pas été représentée,
[Fig. 4] est une photographie d'une bille de PSE activée (revêtue d'une fine couche d'argent) telle qu'obtenue à l'issue de l'étape C) d'activation du procédé selon l'invention,
[Fig. 5] est une photographie d'une bille de PSE activée et revêtue d'une couche de cuivre, telle qu'obtenue à l'issue de l'étape D) de métallisation avec du cuivre du procédé selon l'invention,
[Fig. 6] est une photographie d'une bille de PSE activée et revêtue successivement de couches de cuivre et de nickel chimique (NiP), telle qu'obtenue à l'issue de l'étape E) de métallisation avec du nickel chimique du procédé selon l'invention,
[Fig. 7] est une photographie d'une bille de soudure selon l'invention, consistant en une bille de PSE activée et revêtue successivement de couches de cuivre, de nickel chimique (NiP) et d'or, telle qu'obtenue à l'issue de l'étape F) de métallisation avec du nickel chimique du procédé selon l'invention,
[Fig. 8] est une image au microscope optique d'une coupe de bille selon l'invention montrant la bille de PSE support et les couches successives de cuivre, nickel chimique et d'or telle qu'obtenue à l'issue d'un premier mode de réalisation du procédé selon l'invention (bille de PSE d'environ 655 µm de diamètre et couche de cuivre de 17 µm d'épaisseur),
[Fig. 9] montre une première image (A) prise au microscope optique d'une coupe de bille de PSE revêtue de cuivre telle qu'obtenue à l'issue de l'étape D) d'un deuxième mode de réalisation du procédé selon l'invention (bille de PSE de 660 µm de diamètre et couche de cuivre de 15 µm d'épaisseur), et une deuxième image (B) prise au microscope optique d'une coupe de bille de PSE revêtue de cuivre telle qu'obtenue à l'issue de l'étape D) d'un troisième mode de réalisation du procédé selon l'invention (bille de PSE de 630 µm de diamètre et couche de cuivre de 31 µm d'épaisseur),
[Fig. 10] montre une première image A prise au microscope optique montrant des billes support 10 en PSE présentant une distribution en taille D₀ comprise entre 0.5 et 1 mm, et une deuxième image B prise au microscope optique montrant des billes support 10 en PSE obtenues après tri granulométrique sélectionnant des diamètres compris entre 0.63 et 0.66 mm.
[Fig. 11] montre des billes 1 métallisées selon l'invention avec des diamètres de l'ordre de 400 µm +/-5%,
[Fig. 12] est une image MEB montrant des billes 1 métallisées selon l'invention avant traitement thermique à 360°C (A) et une image MEB montrant des billes 1 métallisées selon le procédé de l'invention et ayant été soumises à un traitement thermique ultérieur à 360°C pendant 20 min (B) pour vérifier la tenue thermique des billes.
[Fig. 13] est une image MEB montrant des billes avec un coeur en polystyrène dense qui ont été métallisées conformément aux étapes A à G du procédé selon l'invention, et ayant été soumises à un traitement thermique ultérieur à 360°C pendant 20 min (B) pour vérifier la tenue thermique des billes.

[Fig. 1] est décrite dans la présentation de l'état de la technique connu. Elle montre en particulier des billes souples présentant des contacts à souder 1, 2 permettant facilement leur assemblage. Fig. 2 à Fig. 12 sont décrites plus en détail au niveau des exemples qui suivent, qui illustrent l'invention sans en limiter la portée.

### EXEMPLES

### DISPOSITIFS ET INSTRUMENTATION

- dispositif de dépôt chimique auto-catalytique (pour le dépôt de cuivre et de nickel chimique) ;
- Dispositif de tamisage mécanique

### PRODUITS DE DEPART

- Billes de polystyrène expansé (PSE) de diamètre compris entre 595 µm et 665 µm ;
- Billes de polystyrène expansé (PSE) de diamètre de l'ordre de 400 µm,
- Nickel chimique (contenant 7 à 10 % en poids de P),
- Cuivre,
- Nitrate d'argent,
- Ions d'or.

### CARACTERISATION : ANALYSE MORPHOLOGIQUE

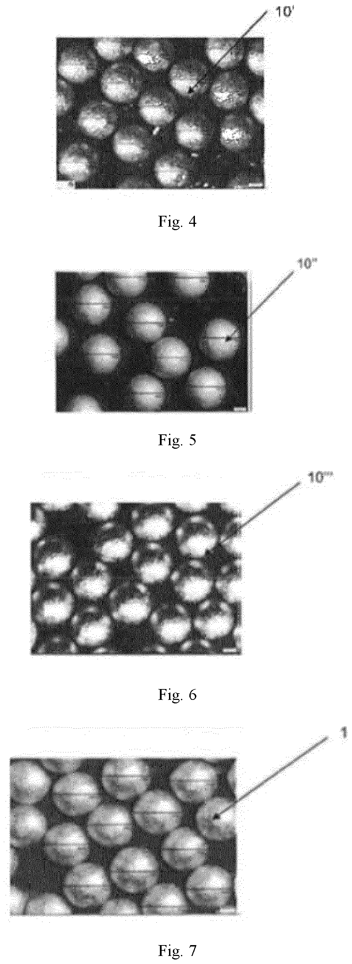

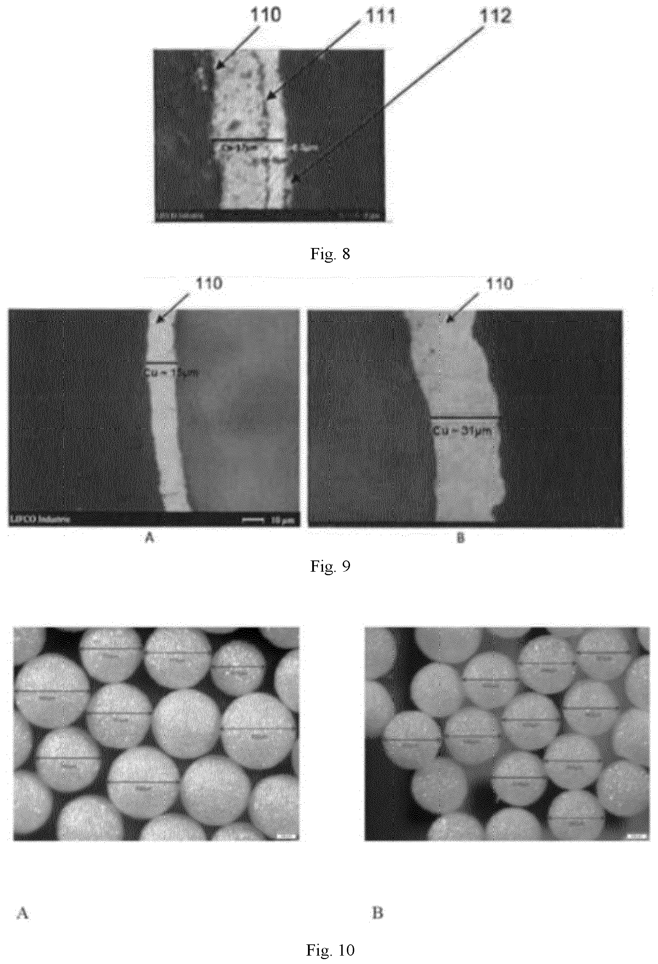

Les observations au microscope optique sont réalisées à l'aide d'un microscope optique, en surface ([Fig. 4] à [Fig. 7]) et en coupe transversale ([Fig. 8] et [Fig. 9]).

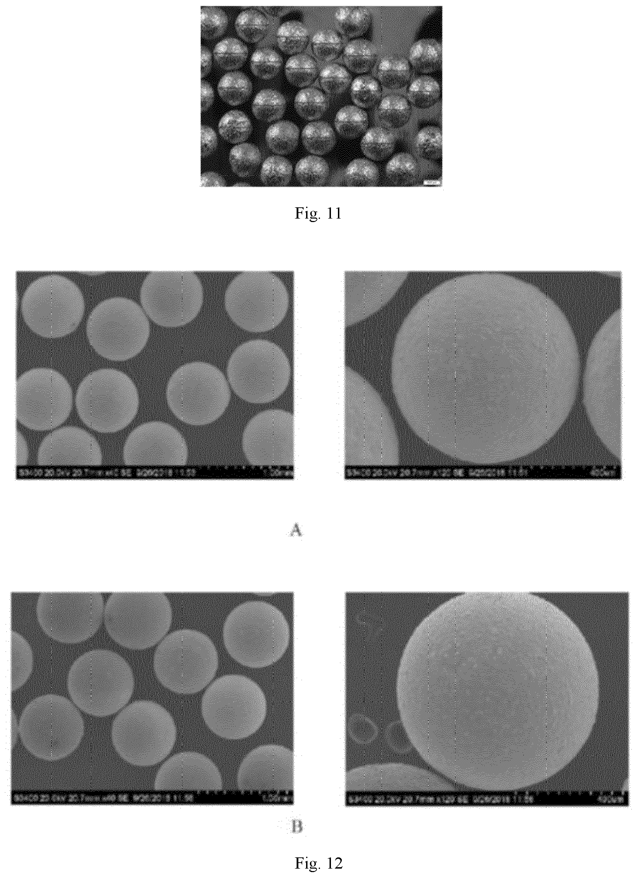

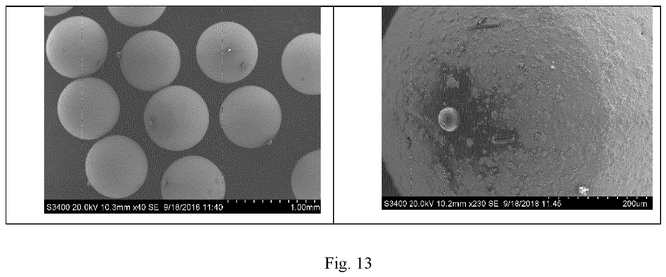

Les observations des figures 12 et 13 sont obtenues à l'aide d'un microscope électronique à balayage (MEB).

### EXEMPLE 1 :

### Fabrication de billes de soudure selon l'invention conformément à un premier mode de réalisation du procédé selon l'invention.

Des billes de soudure selon l'invention sont élaborées à partir de billes de polystyrène expansé (PSE) selon un premier mode de réalisation du procédé selon l'invention. La fabrication est décomposée selon les étapes suivantes :
- 1) On procède à un premier tamisage mécanique de billes de PSE 10 ayant une distribution en taille comprise entre 0.5 et 1 mm pour ne conserver que les billes ayant un diamètre de l'ordre de 630 µm ([Fig. 10]) ;
- 2) Puis, on active la surface des grains de PSE afin de permettre une bonne accroche du traitement de métallisation ultérieur. La bille activée 10' est obtenue en déposant en surface des billes des germes d'argent. L'opération est menée en bain par réduction du nitrate d'argent. A l'issue de ce traitement, on obtient une bille 10' telle que montrée à [Fig. 4];
- 3) La troisième étape consiste à réaliser le traitement de métallisation par du cuivre. Une couche de cuivre 110 de 30 µm d'épaisseur Ecu est obtenue par dépôt chimique auto-catalytique (cf. ([Fig. 2], ([Fig. 3]). A l'issue de ce traitement, on obtient une bille 10" telle que montrée à [Fig. 5] (vue surfacique) ou à [Fig. 9], partie B (vue transversale) ;
- La quatrième étape consiste à déposer une couche de nickel chimique (NiP) 111 de 5 µm d'épaisseur sur la couche de cuivre 110 (cf. [Fig. 2], ([Fig. 3]). Ce revêtement est également réalisé par dépôt chimique auto-catalytique. A l'issue de ce traitement, on obtient une bille 10‴ telle que montrée à [Fig. 6] ;
- La dernière couche de métallisation est une couche de finition 112 en Or (cf. [Fig. 2]). Le dépôt est obtenu par déplacement galvanique par suite à une immersion des billes 10‴ revêtues de nickel chimique dans une solution contenant des ions Or. On dépose ainsi une couche d'or dont l'épaisseur E_{Au} est comprise entre 0.05 µm et 0,12 µm (cf. [Fig. 2]). A l'issue de ce traitement, on obtient une bille de soudure 1 telle que montrée à [Fig. 7] ;
- La dernière étape est un tri granulométrique des billes pour ne conserver que des billes selon l'invention 1 de diamètre D_{f} de l'ordre de 700 µm +/-5%.

### EXEMPLE 2 :

### Fabrication de billes de soudure selon l'invention conformément à un deuxième mode de réalisation du procédé selon l'invention

On réalise des billes de soudure selon l'invention de la même manière qu'à l'exemple 1 avec des billes support de 660 µm de diamètre et un dépôt de cuivre de l'ordre de 15 à 17 µm d'épaisseur (cf. figure 8 et 9A).

### EXEMPLE 3 :

### Fabrication de billes de soudure selon l'invention conformément à un troisième mode de réalisation du procédé selon l'invention

On réalise des billes de soudure selon l'invention de la même manière qu'aux exemples 1 et 2, afin d'obtenir des billes de diamètre D_{f} de l'ordre de 400 µm +/-5% (cf. [Fig. 12]).

### EXEMPLE 4 :

### Effet d'un traitement thermique après l'étape de tamisage

Les analyses MEB ([Fig. 12]) montrent des billes métallisées et calibrées selon l'invention avant (12a) et après traitement thermique à 360°C (12b). On observe que les billes n'ont pas subi de dégradations/modifications suite au traitement thermique, démontrant leurs stabilités en température.

### EXEMPLE 5 (comparatif)

Afin d'établir une analyse comparative du poids des billes, 3 lots de billes (de diamètre D₀ 700 µm +/-5%) ont été réalisés selon les étapes A à G du procédé selon la présente invention (métallisation Cu/NiP/Au), puis soumises à un traitement thermique ultérieur à 360°C pendant 20 min (B) pour vérifier la tenue thermique des billes. Pour cela, on a utilisé 3 types de billes support différents :
- un premier lot réalisé à partir de billes en polystyrène expansé (présentant environ 95% de porosité),
- un deuxième lot réalisé à partir de billes en polystyrène réticulé (dense), et
- un troisième lot réalisé à partir de billes métallique en cuivre (dense).

Pour chaque lot, 1000 billes ont été prélevées et pesées. On obtient les résultats suivants rassemblés dans le tableau 1 ci-après :

**Tableau 1**

| Billes support | Poids pour 1000 billes métallisées (g) |
|---|---|
| Polystyrène expansé | 0.225 |
| Polystyrène dense | 0.390 |
| Cuivre dense | 2.100 |

Les billes réalisées selon la présente invention à partir de polystyrène expansé (premier lot) présentent un facteur de réduction de masse compris entre 1.7 et 9.4 comparé aux solutions actuelles (coeur dense en matière organique ou métallique).

D'autre part, il a été remarqué que la stabilité thermique des billes est améliorée avec l'utilisation d'un coeur en PSE (billes selon l'invention du premier lot) comparativement aux billes obtenues à partir d'un coeur dense (billes des deuxième et troisième lots). En effet on constate qu'à partir de 360°C, les billes réalisées à partir de polystyrène dense (billes des deuxième et troisième lots) montrent un défaut de comportement avec l'apparition de « gouttelettes » de matière organique en surface des billes (Figure 1). Le phénomène n'est pas observé sur les billes selon l'invention réalisées à partir de polystyrène expansé (billes du premier lot).

## Revendications

1. Procédé de fabrication de billes (1) de soudure composites métallisées en surface et calibrées de diamètre D_{f}, lesdites billes (10) comprenant :
- un coeur constitué par une particule support (10) de forme sphérique de diamètre D₀, en polystyrène expansé (PSE) et présentant une porosité intragranulaire d'au moins 50%, et,
- une enveloppe (11) recouvrant ladite particule support (10) et formée par une pluralité de couches superficielles métalliques (110, 111, 112), comprenant un revêtement de cuivre d'épaisseur E_{cu}, au moins une couche de nickel d'épaisseur E_{Ni}, et une couche de finition d'or d'une épaisseur E_{Au}, ledit procédé étant **caractérisé en ce qu'**il comprend les étapes suivantes :
A) une première étape de fourniture de particules support (10), suivie par
B) une première étape de tri granulométrique des particules support (10), consistant en une étape de séparation physique et/ou mécanique des particules support (10) présentant un diamètre D₀ tel que D₀ = D_{f}-2^{∗}(E_{Ni}+E_{Cu}+E_{Au}), D₀ pouvant être choisi entre 200 µm et 1000 µm ;
C) une étape de traitement d'activation des particules support (10) ainsi sélectionnées, pour obtenir des particules support activées (10') ;
D) une première étape de métallisation desdites particules support activées (10') par dépôt chimique auto-catalytique d'une ou plusieurs couches de cuivre, cette étape étant répétée jusqu'à obtention d'un revêtement de cuivre d'épaisseur E_{Cu} de cuivre (110) comprise entre 15 et 30 µm, pour obtenir des particules support revêtues de cuivre (10") ;
E) une deuxième étape de métallisation des particules support revêtues de cuivre (10") par dépôt chimique auto-catalytique d'au moins une couche de nickel allié à du phosphore NiP avec un pourcentage massique de 7 à 10% de phosphore par rapport au poids total de ladite couche de NiP, cette étape étant conduite jusqu'à obtention d'une épaisseur E_{Ni} de couche de nickel chimique (111) comprise entre 4 µm et 7 µm , pour obtenir des particules support revêtues de nickel chimique (10‴) ;
F) une troisième étape de métallisation des particules support revêtues de nickel chimique (10‴) consistant en une étape de dépôt d'or par un procédé de déplacement galvanique réalisé par immersion dans une solution aqueuse contenant des ions d'or, de manière à obtenir des billes de soudure composites métallisées et revêtues en surface d'une couche de finition d'or d'une épaisseur E_{Au} comprise entre 0,05 µm et 0,12 µm ; et
G) une deuxième étape de tri granulométrique des particules ainsi métallisées pour trier et sélectionner des billes (1) de soudure composites métallisées en surface présentant un diamètre D_{f} avec une tolérance de +/-5%.

2. Procédé selon la revendication 1, dans lequel l'étape de tri granulométrique B) des particules support (10) consiste en un tamisage mécanique pour trier et sélectionner les particules support (10) présentant un diamètre D₀ choisi entre 200 µm et 1000 µm.

3. Procédé selon la revendication 2, dans lequel le tamisage mécanique B) des particules support (10) est suivi d'un traitement thermique à une température comprise entre 100°C et 120°C, et de préférence entre 110 °C et 120°C, de la tranche supérieure des particules ainsi triées dont la taille est supérieure à D₀ +5%.

4. Procédé selon l'une quelconque des revendications 1 à 3, dans lequel le traitement d'activation des particules support (10) sélectionnées consiste à déposer à leur surface des germes d'argent par introduction dans un bain de nitrate d'argent ou à déposer à leur surface du cuivre en couche mince inférieure ou égale à 1 µm, par dépôt physique en phase vapeur (PVD).

5. Procédé selon l'une quelconque des revendications 1 à 4, comprenant en outre, entre les étapes D) et E), une étape de dissolution partielle ou totale du polystyrène expansé (PSE) constitutif des particules support (10), ou une étape de décomposition par voie thermique partielle ou totale du polystyrène expansé (PSE) constitutif des particules support (10).

6. Utilisation des billes (10) de soudure composites métallisées en surface et calibrées de diamètre D_{f} obtenues par le procédé tel que défini selon l'une quelconque des revendications 1 à 5, pour l'assemblage de cartes électroniques.

## Patentansprüche

1. Verfahren zur Herstellung von auf der Oberfläche metallisierten und kalibrierten Verbundlötkugeln (1) mit dem Durchmesser D_{f}, wobei die Kugeln (10) umfassen:
- einen Kern, der aus einem kugelförmigen Trägerpartikel (10) mit dem Durchmesser D₀ aus geschäumtem Polystyrol (PSE) besteht und eine intragranuläre Porosität von mindestens 50 % aufweist, und
- eine Hülle (11), die den Trägerpartikel (10) bedeckt und aus einer Mehrzahl von metallischen oberflächlichen Schichten (110, 111, 112) gebildet wird, umfassend einen Kupferüberzug mit der Dicke E_{cu}, mindestens eine Nickelschicht mit der Dicke E_{Ni} und eine Golddeckschicht mit der Dicke E_{Au}, wobei das Verfahren **dadurch gekennzeichnet ist, dass** es die folgenden Schritte umfasst:
A) einen ersten Schritt des Bereitstellens von Trägerpartikeln (10), gefolgt von
B) einem ersten Schritt der Korngrößensortierung der Trägerpartikel (10), der aus einem Schritt der physikalischen und/oder mechanischen Trennung der Trägerpartikel (10) besteht, die einen Durchmesser D₀ aufweisen, so dass D₀ = D_{f}-2*(E_{Ni}+E_{Cu}+E_{Au}), wobei D₀ zwischen 200 µm und 1.000 µm gewählt werden kann;
C) einen Schritt der Aktivierungsbehandlung der so selektierten Trägerpartikel (10), um aktivierte Trägerpartikel (10') zu erhalten;
D) einen ersten Schritt der Metallisierung der aktivierten Trägerpartikel (10') durch autokatalytisches chemisches Abscheiden einer oder mehrerer Kupferschichten, wobei dieser Schritt bis zum Erhalten eines Kupferüberzugs mit der Kupferdicke Ecu (110) zwischen 15 und 30 µm wiederholt wird, um mit Kupfer überzogene Trägerpartikel (10") zu erhalten;
E) einen zweiten Schritt der Metallisierung der mit Kupfer überzogenen Trägerpartikel (10") durch autokatalytisches chemisches Abscheiden mindestens einer Schicht aus mit Phosphor legiertem Nickel NiP, mit einem Massenprozentanteil von 7 bis 10 % Phosphor bezogen auf das Gesamtgewicht der NiP-Schicht, wobei dieser Schritt bis zum Erhalten einer Dicke E_{Ni} der Schicht aus chemischem Nickel (111) zwischen 4 µm und 7 µm durchgeführt wird, um mit chemischem Nickel überzogene Trägerpartikel (10‴) zu erhalten;
F) einen dritten Schritt der Metallisierung der mit chemischem Nickel überzogenen Trägerpartikel (10‴), der aus einem Goldabscheidungsschritt durch ein Verfahren zur galvanischen Verlagerung besteht, das durch Eintauchen in eine Goldionen enthaltende wässrige Lösung ausgeführt wird, so dass metallisierte und auf der Oberfläche mit einer Golddeckschicht mit einer Dicke E_{Au} zwischen 0,05 µm und 0,12 µm überzogene Verbundlötkugeln erhalten werden; und
G) einen zweiten Schritt der Korngrößensortierung der so metallisierten Partikel, um auf der Oberfläche metallisierte Verbundlötkugeln (1) zu sortieren und selektieren, die einen Durchmesser D_{f} mit einer Toleranz von +/-5 % aufweisen.

2. Verfahren nach Anspruch 1, bei dem der Schritt B) der Korngrößensortierung der Trägerpartikel (10) aus einem mechanischen Sieben besteht, um Trägerpartikel (10) zu sortieren und selektieren, die einen zwischen 200 µm und 1000 µm gewählten Durchmesser D₀ aufweisen.

3. Verfahren nach Anspruch 2, bei dem auf das mechanische Sieben B) der Trägerpartikel (10) eine thermische Behandlung bei einer Temperatur zwischen 100 °C und 120 °C und bevorzugt zwischen 110 °C und 120 °C der oberen Tranche der so sortierten Partikel folgt, deren Größe mehr als D₀ +5 % beträgt.

4. Verfahren nach einem der Ansprüche 1 bis 3, bei dem die Aktivierungsbehandlung der selektierten Trägerpartikel (10) daraus besteht, an ihrer Oberfläche durch Einbringen in ein Silbernitratbad Silberkeime abzuscheiden oder an ihrer Oberfläche durch physikalische Gasphasenabscheidung (PVD) Kupfer in dünner Schicht kleiner als oder gleich 1 µm abzuscheiden.

5. Verfahren nach einem der Ansprüche 1 bis 4, ferner umfassend, zwischen den Schritten D) und E), einen Schritt der teilweisen oder vollständigen Auflösung des geschäumten Polystyrols (PSE), aus dem die Trägerpartikel (10) bestehen, oder einen Schritt der teilweisen oder vollständigen thermischen Zersetzung des geschäumten Polystyrols (PSE), aus dem die Trägerpartikel (10) bestehen.

6. Verwendung der mit einem Verfahren nach einem der Ansprüche 1 bis 5 auf der Oberfläche metallisierten und kalibrierten Verbundlötkugeln (10) mit dem Durchmesser D_{f} bei der Montage von Leiterplatten.

## Claims

1. Method for producing composite solder balls (1) with metallized surface which have a diameter D_{f}, , said balls (10) comprising:
- a core consisting of a spherical support particle (10) which has a diameter D₀, made of expanded polystyrene (EPS) and has an intragranular porosity of at least 50%, and,
- a coating (11) which covers said support particle (10) and is formed by a plurality of metal surface layers (110, 111, 112), comprising a copper coating having a thickness E_{cu}, at least one nickel layer having a thickness E_{Ni}, and a gold top layer having a thickness E_{Au}, said method being **characterized in that** it comprises the following steps:
A) a first step of providing the support particles (10), followed by
B) a first step of sorting the support particles (10) by particle size, consisting of a step of physically and/or mechanically separating the support particles (10) having a diameter D₀ such as D₀ = D_{f}-2*(E_{Ni}+E_{Cu}+E_{Au}), it being possible for D₀ to be selected between 200 µm and 1000 µm;
C) a step of actively treating the support particles (10) thus selected, in order to obtain activated support particles (10');
D) a first step of metallizing said activated support particles (10') by auto-catalytic chemical deposition of one or more copper layers, this step being repeated until a copper coating having a copper thickness Ecu (110) of between 15 and 30 µm is obtained, in order to obtain copper-coated support particles (10");
E) a second step of metallizing the copper-coated support particles (10") by auto-catalytic chemical deposition of at least one nickel layer alloyed with phosphorus NiP having a phosphorous mass percentage of 7 to 10% relative to the total weight of said NiP layer, this step being carried out until a chemical nickel layer thickness E_{Ni} (111) of between 4 µm and 7 µm has been obtained, in order to obtain chemical nickel-coated support particles (10‴);
F) a third step of metallizing the chemical nickel-coated support particles (10‴) consisting of a gold deposition step by means of a galvanic displacement method carried out by immersion in an aqueous solution containing gold ions, so as to obtain composite solder balls which are metallized and coated on the surface with a gold top layer having a thickness E_{Au} of between 0.05 µm and 0.12 µm; and
G) a second step of sorting the particles thus metallized by particle size to sort and select composite solder balls (1) having a metallized surface and a diameter D_{f} with a tolerance of +/-5%.

2. Method according to claim 1, wherein the step B) of sorting the support particles (10) by particle size consists of mechanical sieving to sort and select the support particles (10) having a diameter D₀ selected from 200 µm and 1000 µm.

3. Method according to claim 2, wherein the mechanical sieving B) of the support particles (10) is followed by heat treatment at a temperature of between 100°C and 120°C, and preferably between 110°C and 120°C, of the upper edge surface of the particles thus sorted, the size of which being greater than D₀+5%.

4. Method according to any of claims 1 to 3, wherein the activation treatment of the selected support particles (10) consists in depositing silver nuclei on their surface by introduction into a silver nitrate bath or in depositing a thin layer of copper on their surface, which is lower than or equal to 1 pm, by physical vapor deposition (PVD).

5. Method according to any of claims1 to 4, further comprising, between steps D) and E), a step of partially or totally dissolving the expanded polystyrene (EPS) constituting the support particles (10), or a step of dissolving, by means of partial or total thermal decomposition, the expanded polystyrene (EPS) constituting the support particles (10).

6. Use of the composite solder balls (10) with metallized surface and a diameter Df, which are obtained by the method as defined according to any of claims1 to 5 for the assembly of electronic boards.
